# EUROPEAN PATENT APPLICATION

(11) **EP 4 645 588 A1**
(43) Date of publication of application: **05.11.2025**
(21) Application number: 22970274.1
(22) Date of filing: 30.12.2022
(51) Int. Cl.: H01Q 1/12, H01Q 1/38, H01Q 1/32

(54) **ANTENNA ASSEMBLY**

(71) Applicant: LG Electronics Inc., Yeongdeungpo-gu Seoul 07336 (KR)
(72) Inventor: LEE, Soyeon, Seoul 06772 (KR); JUNG, Kangjae, Seoul 06772 (KR); JUNG, Byungwoon, Seoul 06772 (KR); KIM, Dongjin, Seoul 06772 (KR); PARK, Byeongyong, Seoul 06772 (KR); YOU, Dongjoo, Seoul 06772 (KR)
(74) Representative: Vossius & Partner Patentanwälte Rechtsanwälte mbB
(86) International application number: PCT/KR2022/021697
(87) International publication number: WO 2024/143636

(57) **Abstract**

Disclosed is an antenna assembly. The antenna assembly may include: glass having a first region and a second region; an antenna located in the first region; a connection module located in the second region; and a substrate electrically connected to the antenna and connecting the antenna and the connection module, wherein the connection module may include: a lower housing which is coupled to the glass and on which a portion of the substrate is placed; an upper housing which is opposite the lower housing with respect to the substrate and coupled to the lower housing; and a connector which is positioned between the substrate and the upper housing and electrically connected to the substrate.

## Description

### TECHNICAL FIELD

The present disclosure relates to an antenna assembly. More specifically, the present disclosure relates to an assembly including an antenna and a connector connected to the antenna through a substrate to allow the assembly to be coupled to a cable through the connector.

### BACKGROUND ART

A vehicle is a means of transportation that is operated and driven by a driver. As the functions and performance of vehicles develop, the importance of wireless communication systems, which enable vehicles to communicate wirelessly with other vehicles, surrounding objects, and base stations, is increasing. With the commercialization of wireless communication systems using 5G communication technology in the near future, a wider variety of services is expected to be provided through vehicles.

In relation to this wireless communication system, an antenna for enabling conventional wireless communication is mounted on the vehicle body or roof. However, the conventional antenna is disadvantageous in that the signal transmission and reception rates are significantly reduced due to the material of the body or roof.

In addition, an RF cable for enabling conventional wireless communication is soldered to a feeding board connected to an antenna. However, in the case of the conventional method, antenna-related components are not suitable to assemble and are bulky, making transportation difficult.

### DETAILED DESCRIPTION OF INVENTION

### TECHNICAL PROBLEMS

It is an object of the present disclosure to solve the aforementioned problems and other problems.

Another object may be to provide an antenna assembly including an antenna, and a connector connected to the antenna through a substrate.

Another object may be to provide an antenna assembly that is attached to one or two sheets of glass.

Another object may be to provide a connection module that is equipped with a connector and attached to glass together with an antenna.

Another object may be to provide a connection module that stably holds a feeding board and a connector while being attached to glass.

### TECHNICAL SOLUTION

In accordance with an aspect of the present disclosure for achieving the above and other objects, an antenna assembly may include: glass having a first region and a second region; an antenna positioned in the first region; a connection module positioned in the second region; and a substrate electrically connected to the antenna, the substrate being flexible and connecting the antenna and the connection module, wherein the connection module may include: a lower housing coupled onto the glass and on which a portion of the substrate is seated; an upper housing opposite the lower housing with respect to the substrate and coupled to the lower housing; and a connector disposed between the substrate and the upper housing and electrically connected to the substrate, wherein the antenna assembly may further include a plate disposed between the substrate and the connector and coupled to the substrate, wherein the lower housing may include: a hole formed in the lower housing and positioned opposite the plate with respect to the substrate; and a round portion stepped from the glass and having a curved surface, wherein the connector may include pins which protrude from the connector toward the hole, which pass through the plate and the substrate, and which are coupled to the substrate, wherein the pins may be spaced apart from the second region, and wherein the substrate may include a curved portion positioned on the curved surface of the round portion and extending along the curved surface.

### EFFECT OF INVENTION

An antenna assembly according to the present disclosure has the following effects.

According to at least one of the embodiments of the present disclosure, it is possible to provide an antenna assembly including an antenna, and a connector connected to the antenna through a substrate.

According to at least one of the embodiments of the present disclosure, it is possible to provide an antenna assembly that is attached to one or two sheets of glass.

According to at least one of the embodiments of the present disclosure, it is possible to provide a connection module that is equipped with a connector and attached to glass together with an antenna.

According to at least one of the embodiments of the present disclosure, it is possible to provide a connection module that stably holds a feeding board and a connector while being attached to glass.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### BRIEF DESCRIPTION OF THE DRAWING

FIG. 1 is a diagram illustrating a vehicle according to an embodiment of the present disclosure.
FIG. 2 is a configuration diagram of a vehicle according to an embodiment of the present disclosure.
FIGS. 3 to 23 are diagrams illustrating examples of an antenna assembly according to embodiments of the present disclosure.

### MODE FOR CARRYING OUT THE INVENTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand various technical features and it should be understood that the embodiments disclosed herein are not limited by the accompanying drawings. As such, the present disclosure should be construed to extend to any alterations, equivalents, and substitutes in addition to those which are particularly set out in the accompanying drawings.

Although the terms "first", "second", etc. may be used herein to describe various elements, these elements should not be limited by these terms. These terms are only used to distinguish one element from another.

It will be understood that when a component is referred to as being "coupled" or "connected" to another component, it may be directly coupled or connected to another component, or intervening components may be present. In contrast, when a component is referred to as being "directly coupled" or "directly connected" to another component, there are no intervening components present.

A singular representation may include a plural representation unless the context clearly indicates otherwise.

Terms such as "comprises or includes" or "has" are used herein and should be understood that they are intended to indicate an existence of features, numbers, steps, operations, elements, components, or combinations thereof, disclosed in the specification, but do not preclude the presence or addition of one or more other features, numbers, steps, operations, elements, components, or combinations thereof.

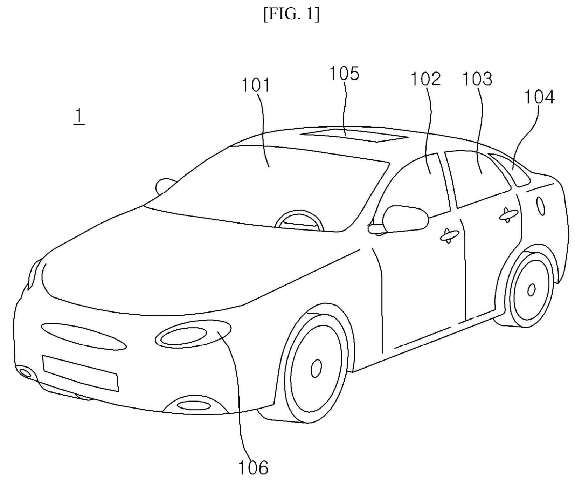

Referring to FIG. 1, a vehicle 1 may be equipped with at least one communication antenna. The vehicle 1 may transmit and receive signals in various frequency bands using the antenna. For example, the vehicle 1 may transmit and receive signals such as GPS, 4G wireless communication, 5G wireless communication, Bluetooth, or wireless LAN. For example, the vehicle 1 performs communication such as Vehicle-to-Vehicle (V2V) communication, Vehicle-to-Infrastructure (V2I) communication, Vehicle-to-Pedestrian (V2P) communication, or Vehicle-to-Network (V2N) communication.

The antenna may consist of a substrate made of a material such as PET (polyethylene terephthalate), and an antenna pattern formed on the substrate. For example, the antenna may be a transparent antenna.

The antenna may be disposed in or on a dielectric of the vehicle 1. The antenna may be disposed in or on the glass of the vehicle 1. The antenna may be coupled or attached to a front windshield 101, door glass 102 and 103, quarter glass 104, a rear windshield (not shown), a side mirror (not shown), a sunroof 105, or lamp glass 106 of the vehicle 1. For example, the antenna may be a transparent antenna.

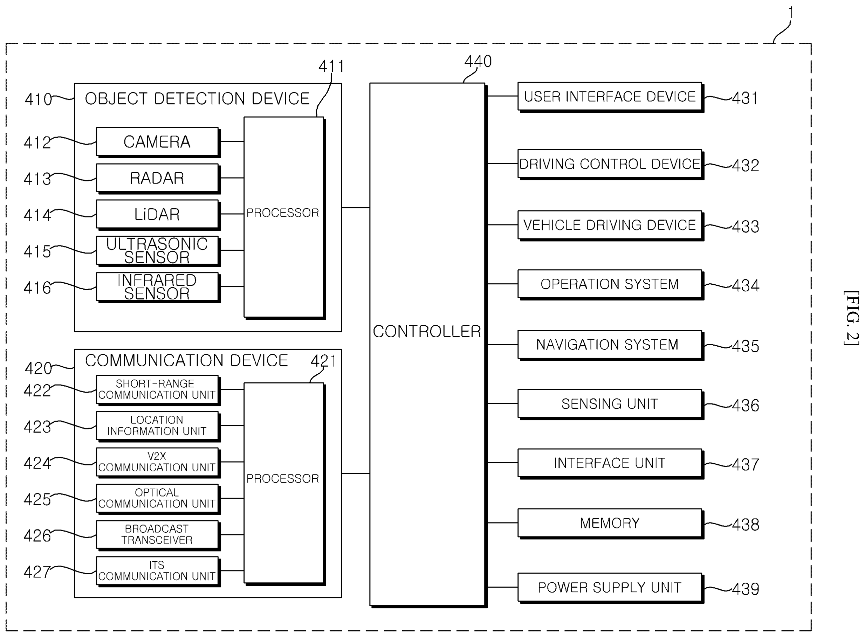

Referring to FIG. 2, the vehicle 1 may include an object detection device 410, a communication device 420, a user interface device 431, a driving control device 432, a vehicle driving device 433, an operation system 434, a navigation system 435, a sensing unit 436, an interface unit 437, a memory 438, a power supply unit 439, and/or a controller 440. Alternatively, the vehicle 1 may further include other components in addition to the above components or may not include some of the above components.

The object detection device 410 may be a device for detecting objects located outside the vehicle 1. For example, the object detection device 410 may include a processor 411, a camera 412, a radar 413, a LiDAR 414, an ultrasonic sensor 415, and/or an infrared sensor 416.

The communication device 420 may be a device for performing communication with an external device. The communication device 420 may include at least one of a transmitting antenna, a receiving antenna, or a radio frequency (RF) circuit or RF component capable of implementing various communication protocols to enable communication. For example, the communication device 420 may include a processor 421, a short-range communication unit 422, a location information unit 423, a V2X communication unit 424, an optical communication unit 425, a broadcast transceiver 426, and/or an ITS communication unit 427.

The user interface device 431 may be a device for communication between the vehicle 1 and a user. The vehicle 1 may implement a user interface (UI) or user experience (UX) through the user interface device 431.

The driving control device 432 may be a device for receiving a user input for driving. The vehicle driving device 433 may be a device that electrically controls the driving of various devices in the vehicle 1. The operation system 434 may be a system that controls various operations of the vehicle 1. The navigation system 435 may provide navigation information. The sensing unit 436 may sense the state of the vehicle 1.

The interface unit 437 may serve as an interface with various types of external devices connected to the vehicle 1. The memory 438 may store basic data for the units, control data for controlling the operation of the units, input/output data, etc. The power supply unit 439 may supply power required for the operation of each component. The controller 440 may control the overall operation of each unit in the vehicle 1. The controller 440 may be referred to as an electronic control unit (ECU).

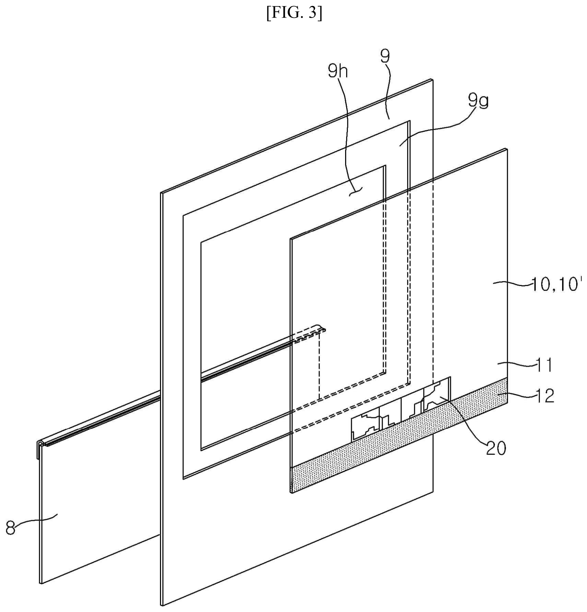

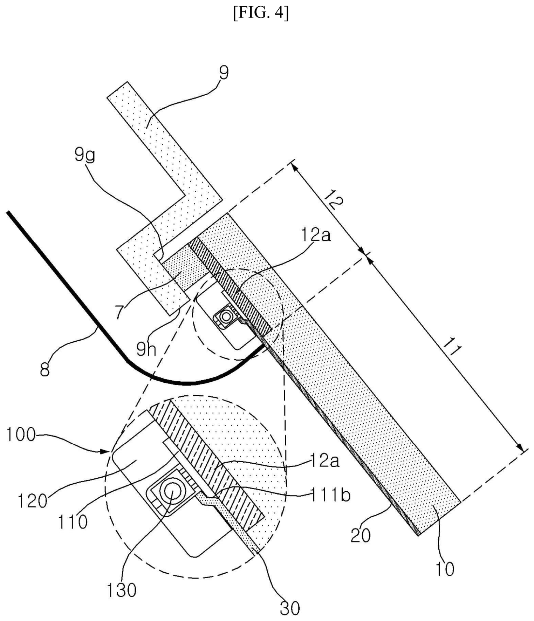

Referring to FIGS. 3 and 4, glass 10, 10' may be coupled or attached to a frame 9 of the vehicle, and may cover an opening 9h of the frame 9. For example, the glass 10, 10' may be the glass of the vehicle 1 such as the front windshield 101, the door glass 102 and 103, the quarter glass 104, the rear windshield, the side mirror, the sunroof 105, or the lamp glass 106 (see FIG. 1). A groove 9g of the frame 9 may extend along an edge of the glass 10, 10' and may define a boundary of the opening 9h. For example, the frame 9 may include a metal material, and a sealant 7 may be filled between the groove 9g and the glass 10, 10'.

An antenna 20 may be positioned on one surface of the glass 10 or inside the glass 10'. The antenna 20 may be transparent. The antenna 20 may be flexible.

A connection module 100 may be disposed between the edge of the glass 10, 10' and the antenna 20, and may be positioned on the one surface of the glass 10. A connector 130 of the connection module 100 may be electrically connected to the antenna 20 through a substrate 30. An inner cover 8 may be positioned opposite the glass 10, 10' with respect to the frame 9, and may cover the connection module 100. The inner cover 8 may be referred to as an interior cover 8. The connection module 100 may be referred to as a connector device 100 or a connector assembly 100.

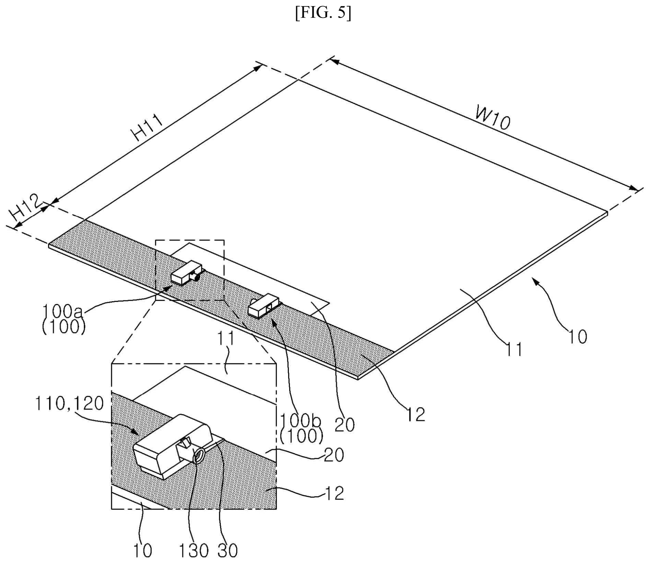

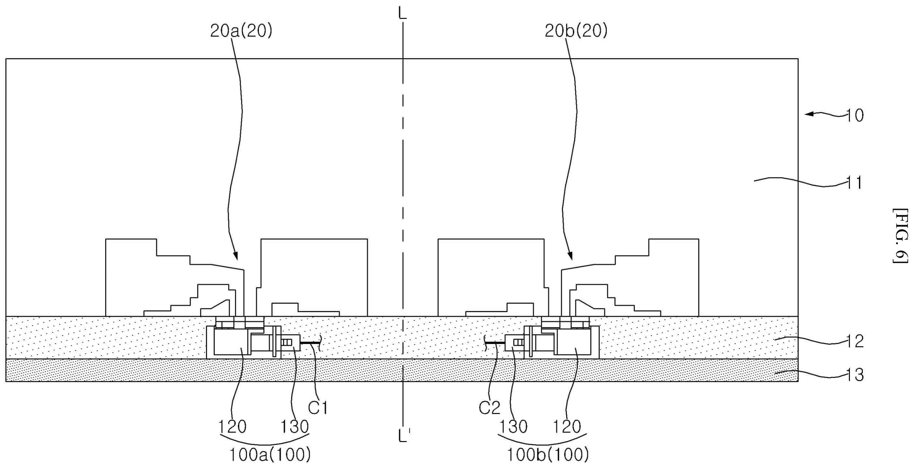

Referring to FIGS. 5 and 6, the glass 10 may include a transparent region 11 and an opaque region 12. The opaque region 12 may be a black masking region or a frit region. For example, the transparent region 11 may occupy most of the glass 10, and the opaque region 12 may be adjacent to one edge of the glass 10. The transparent region 11 and the opaque region 12 may have the same width W10, and a height H11 of the transparent region 11 may be greater than a height H12 of the opaque region 12.

The antenna 20 may be positioned on the transparent region 11 adjacent to a boundary between the transparent region 11 and the opaque region 12. The connection module 100 may be positioned on the opaque region 12, and the connector 130 of the connection module 100 may be connected to the antenna 20 through the substrate 30. Meanwhile, the connection module 100 may be positioned on the transparent region 11.

The n antennas 20 and n connection modules 100 may be positioned on the glass 10 (where n is a natural number greater than or equal to 1). A first antenna 20a may be positioned on the transparent region 11, and may be electrically connected to a first connection module 100a. A second antenna 20b may be positioned on the transparent region 11 next to the first antenna 20a, and may be electrically connected to a second connection module 100b. For example, the first antenna 20a and the second antenna 20b may be horizontally symmetrical with respect to a center line LL' of the glass 10. For example, the first connection module 100a and the second connection module 100b may be horizontally symmetrical with respect to the center line LL' of the glass 10.

Meanwhile, a packing member 13 made of rubber may be coupled or attached to the opaque region 12 at a position adjacent to the connection module 100.

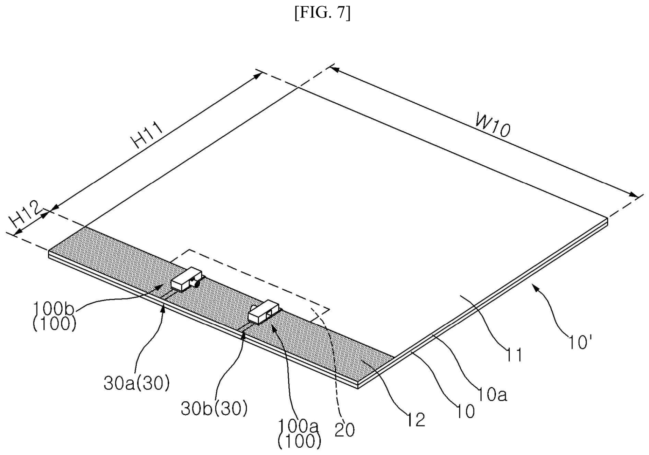

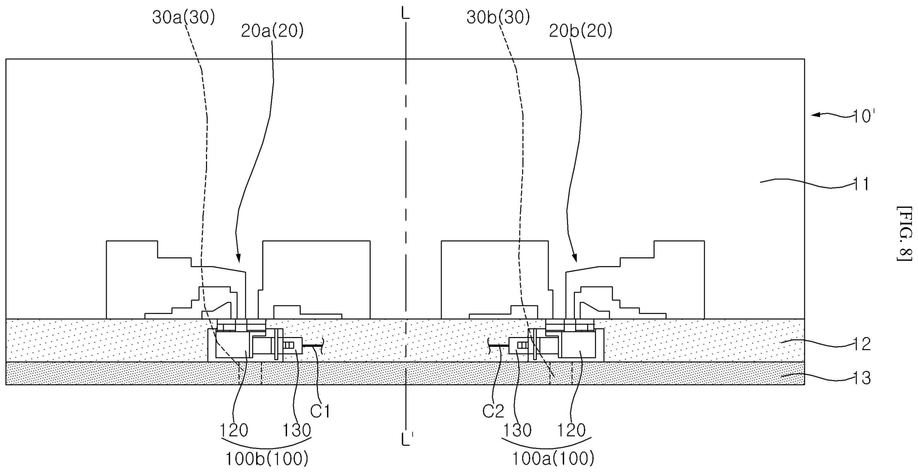

Referring to FIGS. 7 and 8, the glass 10' may be double laminated glass. That is, the glass 10' may include two sheets of glass 10 and 10a superimposed on each other. A first glass 10 may have the transparent region 11 and the opaque region 12 described above. A second glass 10a may have only a transparent region. Alternatively, the second glass 10a may have a transparent region and an opaque region like the first glass 10.

The antenna 20 may be positioned between the first glass 10 and the second glass 10a, corresponding to the transparent region 11. The connection module 100 may be positioned on an area of the second glass 10a corresponding to the opaque region 12 of the first glass 10, and the connector 130 of the connection module 100 may be connected to the antenna 20 through the substrate 30. In this case, a portion of the substrate 30 may be positioned inside the glass 10', and another portion of the substrate 30 may be bent at one edge of the glass 10' to connect the portion of the substrate 30 and the connector 130. Meanwhile, the connection module 100 may be positioned to correspond to the transparent region 11.

The m antennas 20 may be positioned inside the glass 10', and the m connection modules 100 may be positioned on the glass 10' (where m is a natural number greater than or equal to 1). A first antenna 20a may be positioned inside the glass 10' corresponding to the transparent region 11, and may be electrically connected to the second connection module 100b. A second antenna 20b may be positioned inside the glass 10' next to the first antenna 20a, and may be electrically connected to the first connection module 100a. For example, the first antenna 20a and the second antenna 20b may be horizontally symmetrical with respect to a center line LL' of the glass 10'. For example, the second connection module 100b and the first connection module 100a may be horizontally symmetrical with respect to the center line LL' of the glass 10'.

Meanwhile, the substrate 30 of FIGS. 7 and 8 may be connected to the connector 130 by passing through one side of the connection module 100 in an opposite direction toward the antenna 20, and the substrate 30 of FIGS. 5 and 6 may be connected to the connector 130 by passing through one side of the connection module 100 in a direction toward the antenna 20. In this case, the second connection module 100b (see FIGS. 7 and 8) connected to the first antenna 20a may be the same as the second connection module 100b (see FIGS. 5 and 6) connected to the second antenna 20b. In addition, the first connection module 100a (see FIGS. 7 and 8) connected to the second antenna 20b may be the same as the first connection module 100a (see FIGS. 5 and 6) connected to the first antenna 20a.

Meanwhile, a packing member 13 made of rubber may be coupled or attached to a portion of the glass 10' corresponding to the opaque region 12 at a position adjacent to the connection module 100.

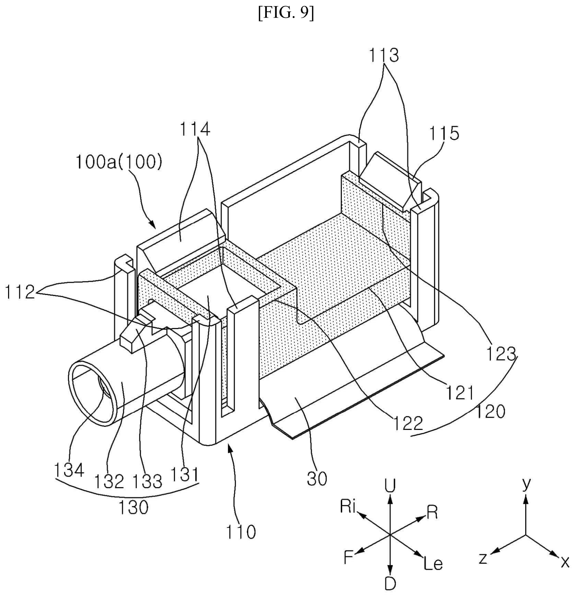

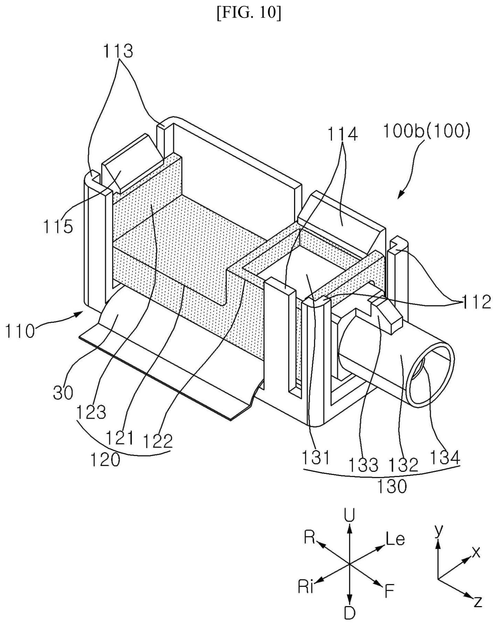

Referring to FIGS. 9 and 10, the directions "up (U)", "down (D)", "left (Le)", "right (Ri)", "front (F)", and "rear (R)" shown in the drawings are merely for convenience of description, and the technical concept disclosed herein is not limited by these directions.

A pair of connection modules 100a and 100b may be symmetrical in the left-right direction. That is, the description of the first connection module 100a can be symmetrically applied to the second connection module 100b (and vice versa). In addition, a first cable C1 connected to a jack 134 of the connector 130 of the first connection module 100a and a second cable C2 connected to a jack 134 of the connector 130 of the second connection module 100b may be horizontally arranged between the first connection module 100a and the second connection module 100b (see FIGS. 5 to 8). For example, the cables C1 and C2 may be detachably coupled to respective latches 133 of the connectors 130. The cables C1 and C2 may be referred to as coaxial cables or RF cables.

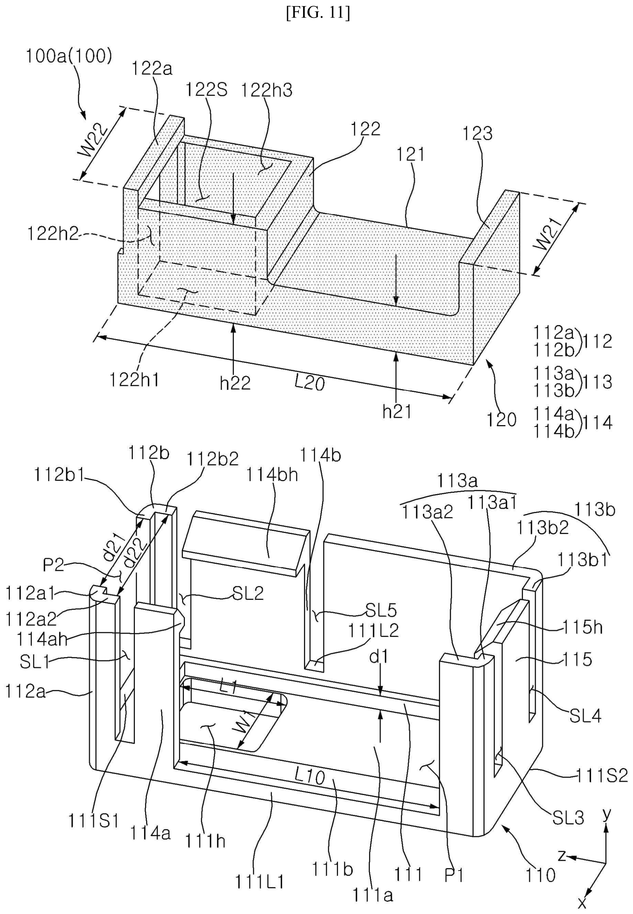

Referring to FIG. 11, the connection module 100 may include a lower housing 110 and an upper housing 120. The lower housing 110 may be referred to as a lower case 110, a bottom housing 110, or a bottom case 110. The upper housing 120 may be referred to as an upper case 120, a top housing 120, or a top case 120. The lower housing 110 and the upper housing 120 may be collectively referred to as a housing (110, 120) or a case (110, 120). For example, the housing (110, 120) may include a plastic material such as polycarbonate (PC).

The lower housing 110 may include a base 111 and walls 112, 113, 114, and 115. The base 111 may be referred to as a bottom plate 111.

The base 111 may generally have the shape of a rectangular plate and may define a bottom of the housing (110, 120). For example, the base 111 may include two long sides 111L1 and 111L2 and two short sides 111S1 and 111S2. A flat surface portion 111a may be formed on an upper surface of the base 111, and a shape the flat surface portion 111a may correspond to a shape of the base 111. The flat surface portion 111a may be a groove, and may be referred to as a flat surface 111a. A hole 111h may be formed through the flat surface portion 111a in a thickness direction of the base 111. For example, the hole 111h may be a rectangular hole with a predetermined width W1 and length L1, and may be adjacent to the first short side 111S1.

The walls 112, 113, 114, and 115 may protrude from edges of the base 111 in a direction intersecting the base 111. For example, the walls 112, 113, 114, and 115 may have the same height or similar heights.

A front wall 112 may be positioned on the first short side 111S1. A first front wall 112a may protrude upward from a corner where the first short side 111S1 and the first long side 111L1 meet. A first part 112a1 of the first front wall 112a may extend along the first short side 111S1, a second part 112a2 of the first front wall 112a may extend along the first long side 111L1, and the first front wall 112a may have an "L" shaped cross-section. A second front wall 112b may protrude upward from a corner where the first short side 111S1 and the second long side 111L2 meet. A first part 112b1 of the second front wall 112b may extend along the first short side 111S1, a second part 112b2 of the second front wall 112b may extend along the second long side 111L2, and the second front wall 112b may have an "L" shaped cross-section. The first front wall 112a and the second front wall 112b may be spaced apart from each other in a longitudinal direction of the first short side 111S1, and may be symmetrical to each other with respect to a center of the first short side 111S1. A second distance d22 between the second parts 112a2 and 112b2 may be less than a first distance d21 between the first parts 112a1 and 112b1.

A rear wall 113 may be positioned on the second short side 111S2. A first rear wall 113a may protrude upward from a corner where the second short side 111S2 and the first long side 111L1 meet. A first part 113a1 of the first rear wall 113a may extend along the second short side 111S2, a second part 113a2 of the first rear wall 113a may extend along the first long side 111L1, and the first rear wall 113a may have an "L" shaped cross-section. A second rear wall 113b may protrude upward from a corner where the second short side 111S2 and the second long side 111L2 meet. A first part 113b1 of the second rear wall 113b may extend along the second short side 111S2, a second part 113b2 of the second rear wall 113b may extend along the second long side 111L2, and the second rear wall 113b may have an "L" shaped cross-section. The first rear wall 113a and the second rear wall 113b may be spaced apart from each other in a longitudinal direction of the second short side 111S2, and may be symmetrical to each other with respect to a center of the second short side 111S2. A second distance between the second parts 113a2 and 113b2 may be less than a first distance between the first parts 113a1 and 113b1. For example, the first and second distances may be equal to the first and second distances d21 and d22, respectively.

A side wall 114 may be positioned on the long sides 111L1 and 111L2. A first side wall 114a may protrude upward from the first long side 111L1, may extend along the first long side 111L1, and may be adjacent to the first short side 111S1. A first side hook 114ah may be formed on an inner surface of the first side wall 114a at a position adjacent to an end of the first side wall 114a. A second side wall 114b may protrude upward from the second long side 111L2, may extend along the second long side 111L2, and may face the first side wall 114a. A second side hook 114bh may be formed on an inner surface of the second side wall 114b at a position adjacent to an end of the second side wall 114b.

A central wall 115 may be positioned at a central portion of the second short side 111S2. The central wall 115 may protrude upward from the second short side 111S2, and may extend along the second short side 111S2. A central hook 115h may be formed on an inner surface of the central wall 115 at a position adjacent to an end of the central wall 115.

A first opening P1 may be formed between the first rear wall 113a and the first side wall 114a. A second opening P2 may be formed between the first front wall 112a and the second front wall 112b.

A first slit SL1 may be formed between the first front wall 112a and the first side wall 114a. A second slit SL2 may be formed between the second front wall 112b and the second side wall 114b. A third slit SL3 may be formed between the central wall 115 and the first rear wall 113a. A fourth slit SL4 may be formed between the central wall 115 and the second rear wall 113b. A fifth slit SL5 may be formed between the second side wall 114b and the second rear wall 113b. The slits SL1, SL2, SL3, SL4, and SL5 may be notches. Accordingly, the side wall 114 and the central wall 115 may be bent relative to the other portion of the lower housing 110 and restored to the original state.

The upper housing 120 may be positioned above the base 111 of the lower housing 110. An edge of a lower surface of the upper housing 120 may form a closed shape that is identical or similar to a boundary of the flat surface portion 111a of the base 111. The upper housing 120 may be disposed between the flat surface portion 111a and the hooks 114ah, 114bh, 115h inside the walls 112, 113, 114, 115 of the lower housing 110. The upper housing 120 may include a cover portion 121, a receiving portion 122, and an engaging portion 123.

The cover portion 121 may have the shape of a solid or hollow block. The cover portion 121 may face a first area of the flat surface portion 111a, and may be adjacent to the rear wall 113 and the central wall 115. The cover portion 121 may be referred to as a pressing portion 121 or a fixing portion 121.

The receiving portion 122 may extend from one end (i.e., a front end) of the cover portion 121 toward the front wall 112, and may face a second area of the flat surface portion 111a. Here, the hole 111h described above may be formed in the second area. An internal space 122S of the receiving portion 122 may communicate with the hole 111h through a first hole 122h1 formed on one surface (i.e., a lower surface) of the receiving portion 122 facing the hole 111h. The internal space 122S of the receiving portion 122 may communicate with the second opening P2 through a second hole 122h2 formed on another surface (i.e., a front surface) of the receiving portion 122 facing the second opening P2. Meanwhile, an upper surface of the receiving portion 122 may be closed or open through a third hole 122h3.

The engaging portion 123 may protrude from another end (i.e., a rear end) of the cover portion 121 toward the central hook 115h. In this case, a height h21 of the cover portion 121 may be less than a height h22 of the receiving portion 122. Alternatively, the height of the cover portion 121 may be equal to the height h22 of the receiving portion 122, and the engaging portion 123 may be omitted.

A first width W21 of the cover portion 121 may be greater than the first distance between the first parts 113al and 113b1 and equal to or less than the second distance between the second parts 113a2 and 113b2. A second width W22 of the receiving portion 122 may be greater than the first distance d21 between the first parts 112a1 and 112b1 and equal to or less than the second distance d22 between the second parts 112a2 and 112b2. For example, the second width W22 may be equal to the first width W21.

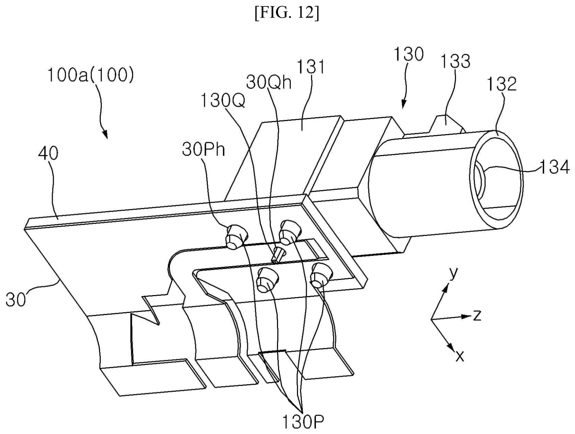

Referring to FIG. 12, the connection module 100 may include a substrate 30, a plate 40, and a connector 130.

The substrate 30 may be a printed circuit board (PCB). The substrate 30 may be a flexible PCB (FPCB). In this case, the substrate 30 may be bendable. The substrate 30 may be referred to as a feeding PCB 30 or a feeding FCB 30.

The plate 40 may be positioned on the substrate 30. For example, the plate 40 may be coupled or attached onto the substrate 30 using an adhesive member such as a double-sided tape. The plate 40 may be a dielectric. The plate 40 may include a plastic material such as epoxy. The plate 40 may be thicker than the substrate 30. The plate 40 can prevent the substrate 30 with a thin thickness from warping during the soldering process of the connector 130, which will be described hereinafter, and the substrate 30, thereby enhancing rigidity of the substrate 30. The plate 40 may be referred to as a reinforcement plate 40 or a support plate 40.

The connector 130 may be positioned opposite the substrate 30 with respect to the plate 40. A plurality of ground pins 130P may protrude from one surface (i.e., a lower surface) of a body 131 facing the plate 40, and may pass through the plate 40 and the substrate 30. A signal pin 130Q may protrude from the one surface of the body 131, and may pass through the plate 40 and the substrate 30. In this case, the plate 40 and the substrate 30 may each have holes 30Ph and 30Qh through which the pins 130P and 130Q pass. For example, the connector 130 may be an RF connector or a FAKRA connector.

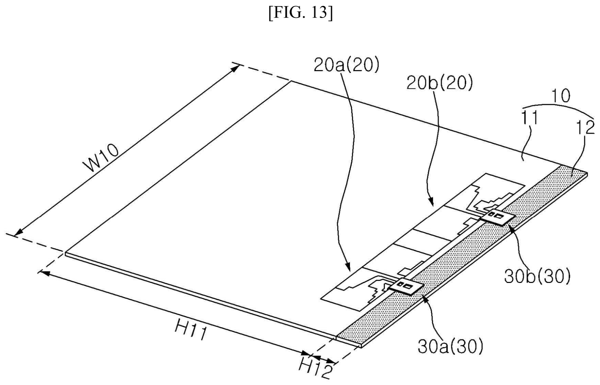

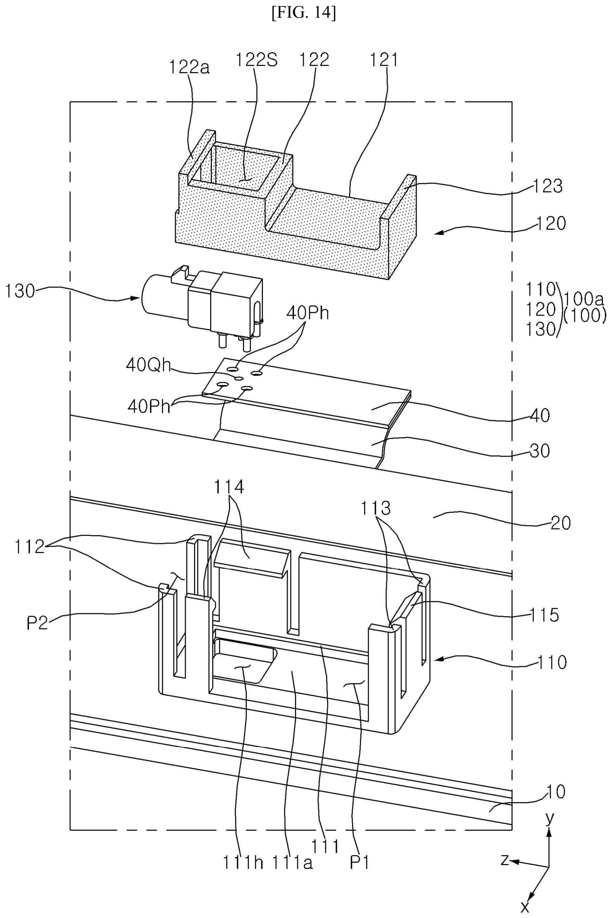

Referring to FIGS. 13 and 14, the antenna 20 and the connection module 100 may be coupled or attached onto the glass 10. One end of the substrate 30 may be electrically connected to the antenna 20, and the connector 130 may be electrically connected to the substrate 30 through holes 40Ph of the plate 40. A portion of the substrate 30 may be sandwiched between parts of the connection module 100, underneath the plate 40.

The glass 10, the antenna 20, the substrate 30, the plate 40, and the connection module 100 may be collectively referred to as an antenna assembly, a communication device, or an electronic device.

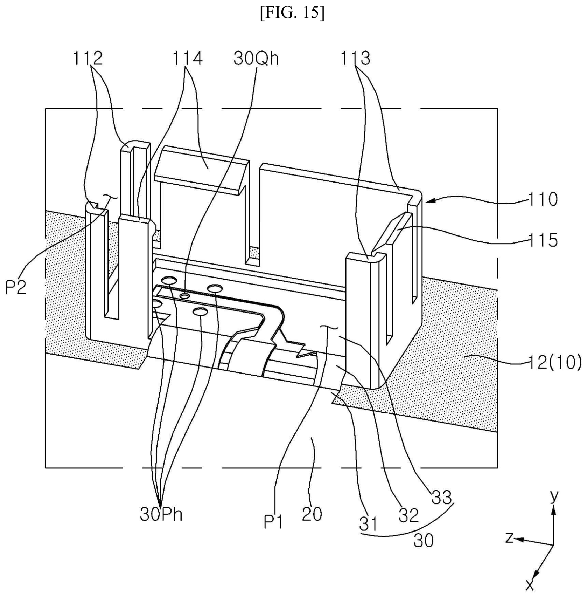

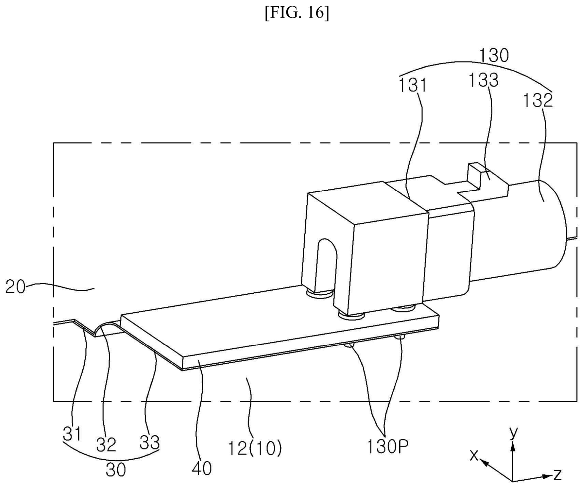

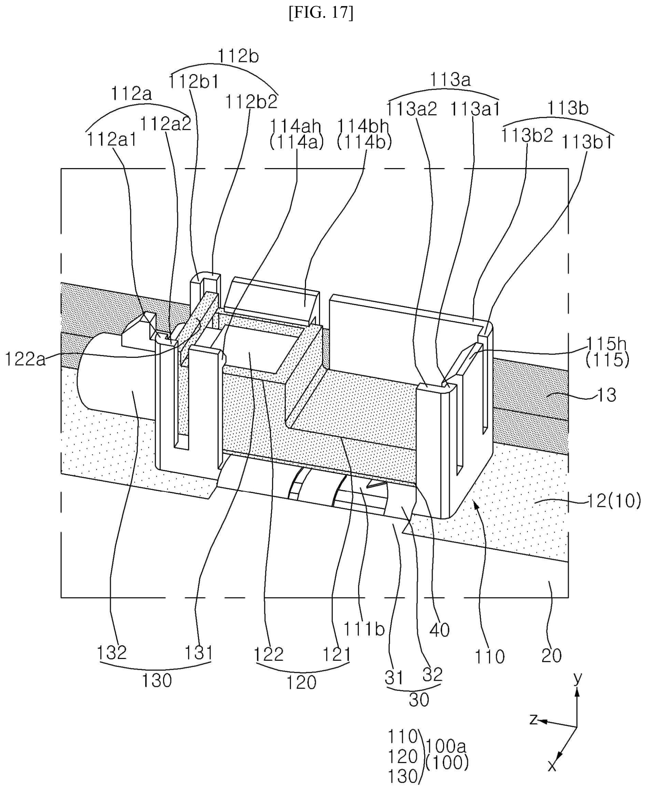

Referring to FIGS. 15 to 17, the antenna 20 may be coupled or attached on the transparent region 11 of the glass 10 using an adhesive member such as an optically clear adhesive film (OCA film). The lower housing 110 may be adjacent to the antenna 20, and may be coupled or attached on the opaque region 12 of the glass 10 using an adhesive member such as double-sided tape.

The substrate 30 may have one end connected to the antenna 20. A portion of the substrate 30 may pass through the first opening P1 (see FIG. 14) and be seated on the groove 111a (see FIG. 14) of the base 111. The plate 40 may be positioned opposite the flat surface portion 111a with respect to the substrate 30, and may be coupled or attached to the substrate 30.

The connector 130 may be positioned opposite the substrate 30 with respect to the plate 40, and may be seated on the plate 40 adjacent to the front wall 112. The pins 130P and 130Q (see FIG. 12) may pass through the plate 40 and the substrate 30 and be soldered to a lower or bottom surface of the substrate 30. A head 132 may extend from the body 131 toward the second opening P2 (see FIG. 14).

The upper housing 120 may be positioned opposite the plate 40 with respect to the connector 130. The plate 40 may contact a lower surface of the cover portion 121. The body 131 of the connector 130 may pass through the first hole 122h1 (see FIG. 11) of the receiving portion 122 and be accommodated in the internal space 122S (see FIG. 14) of the receiving portion 122. The head 132 of the connector 130 may pass through the second hole 122h2 (see FIG. 11) of the receiving portion 122 and the second opening P2 of the lower housing 110. In addition, a stopper 122a, which is a portion of the receiving portion 122, may define a portion of a boundary of the second hole 122h2, and one side of the connector 130 may be caught on (or stopped by) a lower end of the stopper 122a.

In this case, a front end of the upper housing 120 may be defined by the receiving portion 122, and may be caught on rear ends of the first parts 112a1 and 112b1. A rear end of the upper housing 120 may be defined by the cover portion 121, and may be caught on front ends of the first parts 113al and 113b1. That is, the lower housing 110 may restrict forward and backward movement of the upper housing 120 located inside the lower housing 110.

In addition, a left surface of the upper housing 120 may be caught on the second parts 112a2 and 113a2 and the inner surface of the first side wall 114a. A right surface of the upper housing 120 may be caught on the second parts 112b2 and 113b2 and the inner surface of the second side wall 114b. That is, the lower housing 110 may restrict left and right movement of the upper housing 120 located inside the lower housing 110.

Further, an upper end of the receiving portion 122 may be caught on lower ends of the side hooks 114ah and 114bh. An upper end of the engaging portion 123 (see FIG. 14) may be caught on a lower end of the central hook 115h. That is, the lower housing 110 may restrict vertical movement of the upper housing 120 located inside the lower housing 110.

Accordingly, the substrate 30, the plate 40, and the connector 130 may be held in place without shaking or wobbling between the lower housing 110 and the upper housing 120.

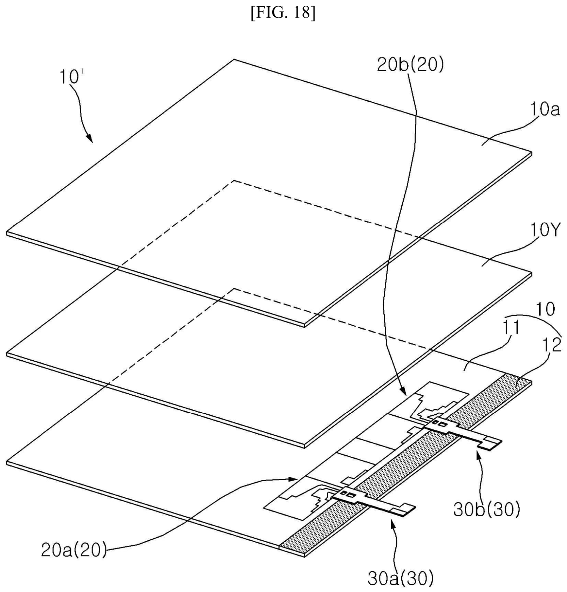

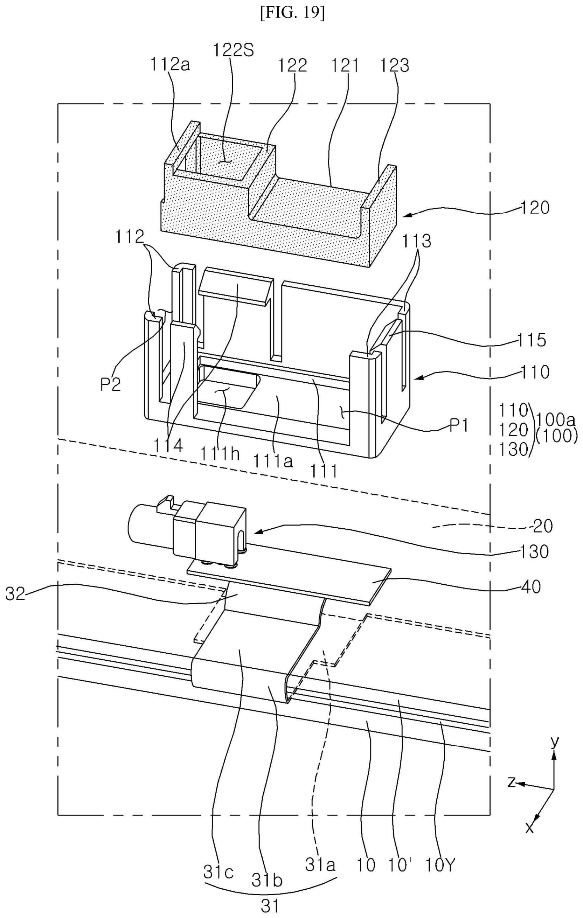

Referring to FIGS. 18 and 19, the glass 10' may include two sheets of glass 10 and 10a coupled or attached to each other, and an adhesive film 10Y sandwiched between the two sheets of glass 10 and 10a. For example, the adhesive film 10Y may be an anti-shatter film made of PVC (Poly Vinyl Chloride).

The antenna 20 may be positioned between the first glass 10 and the adhesive film 10Y or between the second glass 10a and the adhesive film 10Y, corresponding to the transparent region 11. The connection module 100 may be coupled or attached onto the glass 10' corresponding to the opaque region 12.

The connector 130 may be connected to the antenna 20 through the substrate 30. In this case, a portion of the substrate 30 may be positioned inside the glass 10', and another portion of the substrate 30 may be bent at one edge of the glass 10' to connect the portion of the substrate 30 and the connector 130.

The glass 10', the antenna 20, the substrate 30, the plate 40, and the connection module 100 may be collectively referred to as an antenna assembly, a communication device, or an electronic device.

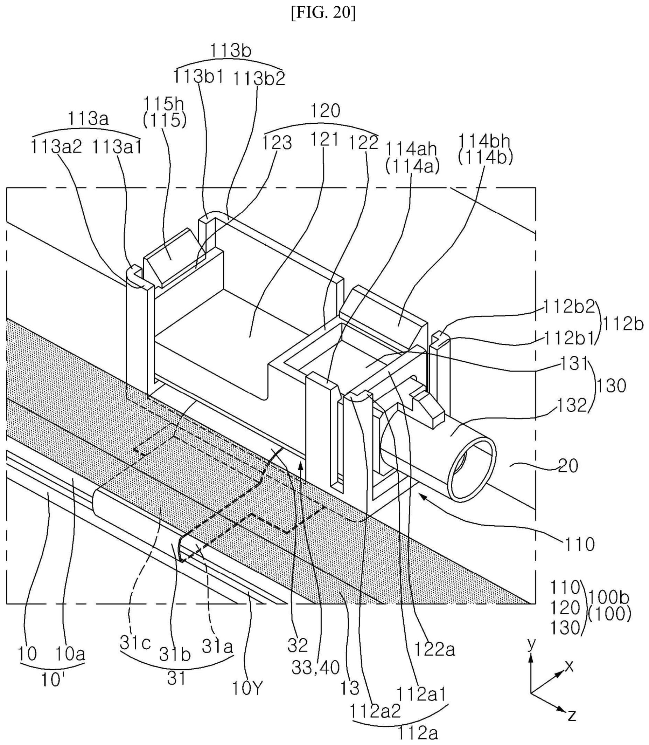

Referring to FIGS. 19 and 20, the antenna 20 may be coupled or attached in the transparent region 11 of the glass 10' using an adhesive member such as an optically clear adhesive film (OCA film). The lower housing 110 may be adjacent to the antenna 20, and may be coupled or attached on the opaque region of the glass 10' using an adhesive member such as double-sided tape.

The substrate 30 may have one end connected to the antenna 20. A first part (or portion) 31a of the substrate 30 may be positioned in the glass 10' at the same level as the antenna 20, and may define the one end of the substrate 30. A second part (or portion) 31b of the substrate 30 may be connected to the first part 31a, and may cover a portion of a lateral side of the glass 10'. A third part (or portion) 31c of the substrate 30 may be connected to the second part 31b, and may be positioned on the glass 10' at the same level as the lower housing 110. A fourth part (or portion) 32 of the substrate 30 may be connected to the third part 31c, and may pass through the first opening P1 (see FIG. 19) and be elevated to the lower housing 110. A fifth part (or portion) 33 of the substrate 30 may be connected to the fourth part 32, and may be seated on the groove 111a (see FIG. 19) of the base 111. The plate 40 may be positioned opposite the flat surface portion 111a with respect to the fifth part 33, and may be coupled or attached to the substrate 30.

Meanwhile, the second part 31b of the substrate 30 may be referred to as a bending portion 31b of the substrate 30. The bending portion 31b may be convex outward of the lateral side of the glass 10'. Accordingly, the bending portion 31b may smoothly connect the first part 31a and the third part 31c. Compared to a case in which a linear portion, instead of the bending portion 31b, is disposed in an angled manner at the first part 31a and the third part 31c, damage to the substrate 30 due to bending of the substrate 30 can be minimized.

The connector 130 may be positioned opposite the fifth part 33 with respect to the plate 40, and may be seated on the plate 40 adjacent to the front wall 112. The pins 130P and 130Q (see FIG. 12) may pass through the plate 40 and the fifth part 33 and be soldered to a lower or bottom surface of the substrate 30. A head 132 may extend from the body 131 toward the second opening P2 (see FIG. 19).

The upper housing 120 may be positioned opposite the plate 40 with respect to the connector 130. The plate 40 may contact a lower surface of the cover portion 121. The body 131 of the connector 130 may pass through the first hole 122h1 (see FIG. 11) of the receiving portion 122 and be accommodated in the internal space 122S (see FIG. 19) of the receiving portion 122. The head 132 of the connector 130 may pass through the second hole 122h2 (see FIG. 11) of the receiving portion 122 and the second opening P2 of the lower housing 110. In addition, a stopper 122a, which is a portion of the receiving portion 122, may define a portion of a boundary of the second hole 122h2, and one side of the connector 130 may be caught on (or stopped by) a lower end of the stopper 122a.

In this case, a front end of the upper housing 120 may be defined by the receiving portion 122, and may be caught on rear ends of the first parts 112a1 and 112b1. A rear end of the upper housing 120 may be defined by the cover portion 121, and may be caught on front ends of the first parts 113a1 and 113b1. That is, the lower housing 110 may restrict forward and backward movement of the upper housing 120 located inside the lower housing 110.

In addition, a right surface of the upper housing 120 may be caught on the second parts 112a2 and 113a2 and the inner surface of the first side wall 114a. A left surface of the upper housing 120 may be caught on the second parts 112b2 and 113b2 and the inner surface of the second side wall 114b. That is, the lower housing 110 may restrict left and right movement of the upper housing 120 located inside the lower housing 110.

Further, an upper end of the receiving portion 122 may be caught on lower ends of the side hooks 114ah and 114bh. An upper end of the engaging portion 123 may be caught on a lower end of the central hook 115h. That is, the lower housing 110 may restrict vertical movement of the upper housing 120 located inside the lower housing 110.

Accordingly, the substrate 30, the plate 40, and the connector 130 may be held in place without shaking or wobbling between the lower housing 110 and the upper housing 120.

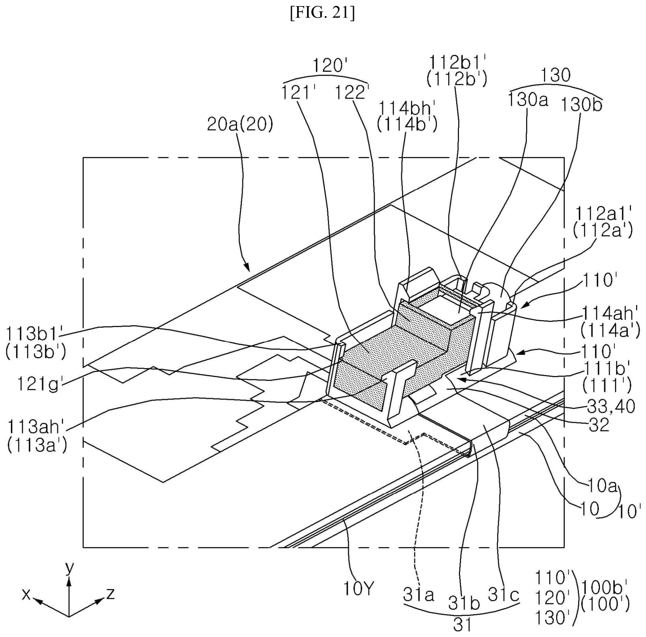

Referring to FIG. 21, a connection module 100' may include a housing (110', 120') instead of the housing (110, 120) described above with reference to FIGS. 18 to 20. Alternatively, the connection module 100' may include a housing (110', 120') instead of the housing (110, 120) described above with reference to FIGS. 13 to 17.

An upper housing 120' may include a cover portion 121' that covers the fifth part 33 of the substrate 30 and the plate 40, and a receiving portion 122' that accommodates the connector 130.

In this case, a front end of the upper housing 120' may be defined by the receiving portion 122', and may be caught on rear ends of first parts 122al' and 122b1' of a lower housing 110'. A rear end of the upper housing 120' may be defined by the cover portion 121', and a rear groove 121g' formed at the rear end of the upper housing 120' may be caught on a front end of a first part 113b1'. That is, the lower housing 110' may restrict forward and backward movement of the upper housing 120' positioned inside the lower housing 110'.

In addition, left and right surfaces of the upper housing 120' may be caught on inner surfaces of walls 112a', 113a', and 114a' of the lower housing 110'. That is, the lower housing 110' may restrict left and right movement of the upper housing 120' positioned inside the lower housing 110'.

Further, an upper end of the receiving portion 122' may be caught on lower ends of side hooks 114ah' and 114bh'. An upper end of the cover portion 121' may be caught on a lower end of a rear hook 113ah'. That is, the lower housing 110' may restrict vertical movement of the upper housing 120' positioned inside the lower housing 110'.

Accordingly, the substrate 30, the plate 40, and the connector 130 may be held in place without shaking or wobbling between the lower housing 110' and the upper housing 120'.

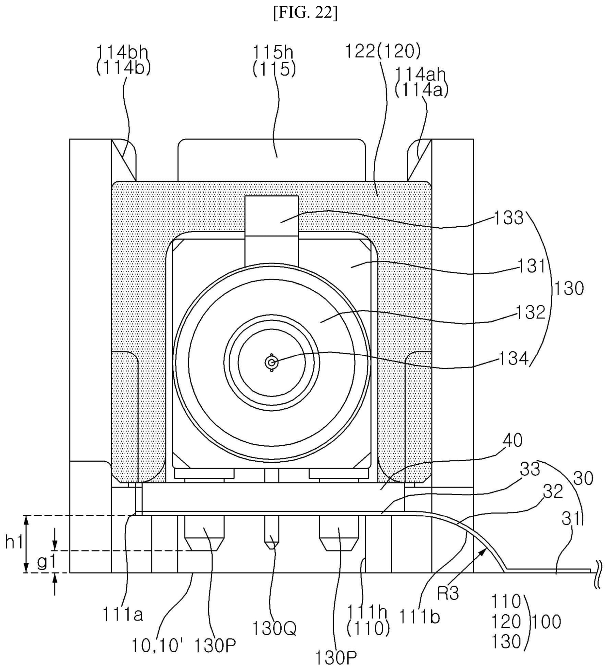

Referring to FIG. 22, the pins 130P and 130Q may protrude from a lower surface of the body 131 of the connector 130 toward the hole 111h of the lower housing 110, and may pass through the plate 40 and the substrate 30. The holes 30Ph and 30Qh (see FIG. 12 and FIG. 15) and the hole 111h may be aligned vertically. Here, a portion of the substrate 30 overlapping the plate 40 may be referred to as a flat portion 33. For example, the flat portion 33 may be the fifth part 33 (see FIG. 19). Portions of the pins 130P and 130Q may be positioned inside the hole 111h, and may be spaced upward from an upper surface of the glass 10, 10' (see a gap g1 between the pins 130P, 130Q and the glass 10, 10').

Accordingly, the connection module 100 may be disposed flat on the glass 10 and 10'.

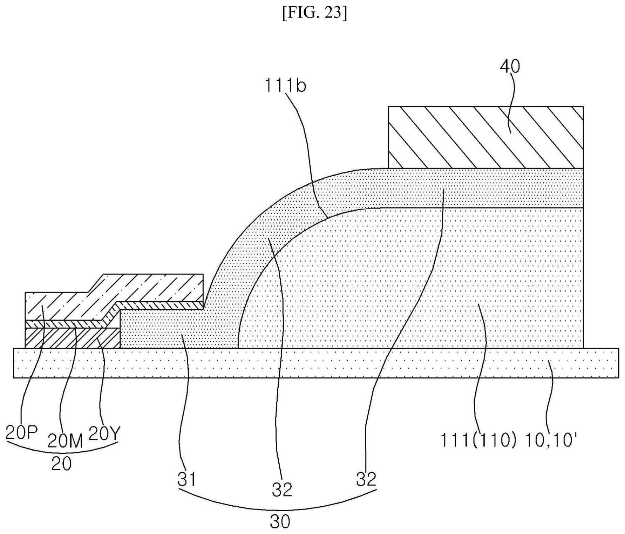

Referring to FIGS. 22 and 23, the substrate 30 may include a connecting portion 31, a curved portion 32, and a flat portion 33. For example, the connecting portion 31 may be the first to third parts 31a, 31b, and 31c (see FIG. 19), the curved portion 32 may be the fourth part 32 (see FIG. 19), and the flat portion 33 may be the fifth part 33 (see FIG. 19).

At least a portion of the connecting portion 31 may be positioned on the glass 10, 10'. The flat portion 33 may overlap the plate 40, and may be seated on the flat surface portion 111a. The curved portion 32 may connect the connecting portion 31 and the flat portion 33, and may be positioned on a round portion 111b of the lower housing 110.

The round portion 111b may be a portion of the lower housing 110 that connects the first long side 111L1 and the flat surface portion 111a of the lower housing 110, and may be formed between the first rear wall 113a and the first side wall 114a (see FIG. 11). A length L10 (see FIG. 11) of the round portion 111b may be equal to or greater than a width of the curved portion 32 (defined in a longitudinal direction of the round portion 111b). The surface of the round portion 111b may be a curved surface. The surface of the round portion 111b may be a convex curved surface with a predetermined radius of curvature R3. Alternatively, the surface of the round portion 111b may be a concave curved surface with a predetermined radius of curvature. The curved portion 32 may be curved along the surface of the round portion 111b, and may be seated on the surface of the round portion 111b.

Accordingly, despite a height difference (see h1) between the upper surface of the glass 10, 10' where the connecting portion 31 is positioned and the upper surface of the flat portion 111a where the flat portion 33 is positioned, the curved portion 32 may smoothly connect the connecting portion 31 and the flat portion 33. In this case, compared to a case in which a linear portion is provided instead of the round portion 111b, damage to the substrate 30 due to bending of the substrate 30 can be minimized.

Meanwhile, the antenna 20 may include a conductive material such as copper, gold, or silver. The antenna 20 may have an antenna pattern in the form of a metal mesh. The metal mesh may be a pattern that implements an electrode by arranging a conductive material such as copper, gold, or silver in a grid pattern. In addition, a transmission line of the antenna pattern may be designed as a co-planar waveguide (CPW). The CPW may have a pattern structure in which a feeding line, which is connected to a radiation pattern, and a ground pattern are spaced apart from each other on the same plane. The layers of the antenna 20 may include a first layer 20M in the form of a metal mesh, a second layer 20P made of a PET material to protect an upper surface of the first layer 20M, and an adhesive member 20Y coupled to a lower surface of the first layer 20M and the upper surface of the glass 10, 10'.

In this case, the first layer 20M may be electrically connected to an upper surface of the substrate 30. The pins 130P and 130Q may pass through the plate 40 and the substrate 30 and be soldered to a lower surface of the substrate 30 (see FIG. 12). The lower surface and the upper surface of the substrate 30 may be electrically connected through a via. Accordingly, the antenna 20 may be electrically connected to the cable C1, C2 (see FIG. 6 and FIG. 8) connected to the jack 134 of the connector 130 through the substrate 30 and the pins 130P and 130Q (see FIG. 12). That is, components of the vehicle 1 (see FIG. 1) connected to the cable C1, C2 may perform communication using the antenna 20.

Referring to FIGS. 1 to 23, according to one aspect of the present disclosure, an antenna assembly may include: glass having a first region and a second region; an antenna positioned in the first region; a connection module positioned in the second region; and a substrate electrically connected to the antenna, the substrate connecting the antenna and the connection module, wherein the connection module may include: a lower housing coupled onto the glass and on which a portion of the substrate is seated; an upper housing opposite the lower housing with respect to the substrate and coupled to the lower housing; and a connector disposed between the substrate and the upper housing and electrically connected to the substrate.

The antenna may be a transparent antenna, the first region may be a transparent region, and the second region may be an opaque region.

The lower housing may include a round portion stepped from the glass and having a curved surface, the substrate may be flexible, and may include a curved portion that is positioned on the curved surface of the round portion and extends along the curved surface.

The lower housing may include a hole formed in the lower housing and positioned opposite the connector with respect to the substrate, the connector may include pins that protrude from the connector toward the hole and pass through the substrate, the pins may be spaced apart from the second region.

The antenna assembly may further include a plate that is disposed between the substrate and the connector and coupled to the substrate, the pins may pass through the plate and the substrate, and may be coupled to the substrate.

The upper housing may include: a cover portion that presses a portion of the plate toward the lower housing; and a receiving portion that provides an internal space where the connector is positioned.

The upper housing may be caught on an inside of the lower housing in a horizontal direction and a vertical direction.

The lower housing may include: a base that forms a bottom; and walls that protrude from an edge of the base in a direction intersecting the base and are spaced apart from each other along the edge, the substrate may pass through a first opening formed between the walls, and the connector may pass through a second opening formed between the walls and facing a different direction from the first opening.

The base may include a groove formed on an upper surface of the base and on which the substrate is seated.

The antenna may include: a first antenna; and a second antenna adjacent to the first antenna, the connection module may include: a first connection module electrically connected to the first antenna; and a second connection module adjacent to the first connection module and electrically connected to the second antenna.

The first and second connection modules may be symmetrical to each other, a connector of the first connection module may include a first head facing the second connection module and to which a first cable is connected, and a connector of the second connection module may include a second head facing the first connection module and to which a second cable is connected.

The antenna may be attached onto the glass.

The glass may include: first glass; and second glass attached onto the first glass, the antenna may be disposed between the first glass and the second glass, the lower housing may be attached onto the second glass, a portion of the substrate may be positioned between the first glass and the second glass, and another portion of the substrate may be connected to the portion and positioned outside the glass.

The substrate may include: a first part positioned between the first glass and the second glass and having one end connected to the antenna; a second part connected to the first part and covering a portion of a lateral side of the second glass; a third part connected to the second part and positioned on the second glass; and a fourth part connecting the third part and the connector, the second part may be formed to have a curvature.

According to another aspect of the present disclosure, a vehicle may include: a cable; and the antenna assembly connected to the cable.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the present disclosure should be determined by reasonable interpretation of the appended claims, and all changes coming within the equivalency range of the present disclosure are intended to be embraced in the scope of the present disclosure.

## Claims

1. An antenna assembly comprising:
glass having a first region and a second region;
an antenna positioned in the first region;
a connection module positioned in the second region; and
a substrate electrically connected to the antenna, the substrate being flexible and connecting the antenna and the connection module,
wherein the connection module comprises:
a lower housing coupled onto the glass and on which a portion of the substrate is seated;
an upper housing opposite the lower housing with respect to the substrate and coupled to the lower housing; and
a connector disposed between the substrate and the upper housing and electrically connected to the substrate,
wherein the antenna assembly further comprises a plate disposed between the substrate and the connector and coupled to the substrate,
wherein the lower housing comprises:
a hole formed in the lower housing and positioned opposite the plate with respect to the substrate; and
a round portion stepped from the glass and having a curved surface,
wherein the connector comprises pins which protrude from the connector toward the hole, which pass through the plate and the substrate, and which are coupled to the substrate,
wherein the pins are spaced apart from the second region, and
wherein the substrate comprises a curved portion positioned on the curved surface of the round portion and extending along the curved surface.

2. The antenna assembly of claim 1, wherein the antenna is a transparent antenna, and
wherein the first region is a transparent region, and the second region is an opaque region.

3. The antenna assembly of claim 1, wherein the upper housing comprises:
a cover portion pressing a portion of the plate toward the lower housing; and
a receiving portion providing an internal space in which the connector is positioned.

4. The antenna assembly of claim 3, wherein the upper housing is caught on an inside of the lower housing in a horizontal direction and a vertical direction.

5. The antenna assembly of claim 1, wherein the lower housing comprises:
a base forming a bottom; and
walls protruding from an edge of the base in a direction intersecting the base and spaced apart from each other along the edge,
wherein the substrate passes through a first opening formed between the walls, and
wherein the connector passes through a second opening formed between the walls and facing a different direction from the first opening.

6. The antenna assembly of claim 5, wherein the base comprises a flat surface portion formed on an upper surface of the base and on which the substrate is seated.

7. The antenna assembly of claim 1, wherein the antenna comprises:
a first antenna; and
a second antenna adjacent to the first antenna, and
wherein the connection module comprises:
a first connection module electrically connected to the first antenna; and
a second connection module adjacent to the first connection module and electrically connected to the second antenna.

8. The antenna assembly of claim 7, wherein the first and second connection
modules are symmetrical to each other,
wherein a connector of the first connection module includes a first head facing the second connection module and to which a first cable is connected, and
wherein a connector of the second connection module includes a second head facing the first connection module and to which a second cable is connected.

9. The antenna assembly of claim 1, wherein the antenna is attached onto the glass.

10. The antenna assembly of claim 1, wherein the glass comprises:
first glass; and
second glass attached onto the first glass,
wherein the antenna is disposed between the first glass and the second glass,
wherein the lower housing is attached onto the second glass, and
wherein a portion of the substrate is positioned between the first glass and the second glass, and another portion of the substrate is connected to the portion and is positioned outside the glass.

11. The antenna assembly of claim 10, wherein the substrate comprises:
a first part positioned between the first glass and the second glass and having one end connected to the antenna;
a second part connected to the first part and covering a portion of a lateral side of the second glass;
a third part connected to the second part and positioned on the second glass; and a fourth part connecting the third part and the connector, and
wherein the second part is formed to have a curvature.

12. A vehicle comprising:
a cable; and
the antenna assembly according to claim 1 connected to the cable.
